(19) Europäisches Patentamt
European Patent Office
Office européen des brevets

(11) **EP 3 651 328 B1**

(12) **FASCICULE DE BREVET EUROPEEN**

(45) Date de publication et mention
de la délivrance du brevet:
**02.11.2022 Bulletin 2022/44**

(21) Numéro de dépôt: **19208658.5**

(22) Date de dépôt: **12.11.2019**

(51) Classification Internationale des Brevets (IPC):
**H02M 1/32** *(2007.01)*    **H02M 3/337** *(2006.01)*
**H02H 7/12** *(2006.01)*    **H02M 1/00** *(2006.01)*

(52) Classification Coopérative des Brevets (CPC):
**H02M 1/32; H02M 3/01;** H02M 1/0058;
H02M 3/33571; Y02B 70/10

(54) **SYSTEME ELECTRIQUE ET METHODE DE PROTECTION D'UN CONVERTISSEUR DC/DC**

ELEKTRISCHES SYSTEM UND METHODE ZUM SCHUTZ EINES
GLEICHSTROM-GLEICHSTROMWANDLERS

ELECTRICAL METHOD FOR PROTECTING A DC/DC CONVERTER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **06.11.2018 FR 1860223**

(43) Date de publication de la demande:
**13.05.2020 Bulletin 2020/20**

(73) Titulaire: **Valeo eAutomotive France SAS
95800 Cergy (FR)**

(72) Inventeurs:
• ZHOU, Huan
  **78800 HOUILLES (FR)**
• YANG, Gang
  **92400 COURBEVOIE (FR)**

(74) Mandataire: **Argyma
14 Boulevard de Strasbourg
31000 Toulouse (FR)**

(56) Documents cités:
EP-A1- 3 588 719    CN-B- 101 997 421
US-A1- 2014 268 907    US-A1- 2015 229 225

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE ET OBJET DE L'INVENTION**

La présente invention concerne le domaine des systèmes d'alimentation d'équipements électriques et/ou électroniques notamment destinés à être embarqués dans un véhicule automobile, en particulier un véhicule automobile électrique ou hybride. La présente invention concerne plus particulièrement le domaine des convertisseurs continu-continu, c'est-à-dire des systèmes électriques permettant de convertir une tension d'entrée continue en une tension de sortie continue, inférieure ou supérieure à la tension d'entrée.

De manière connue, un véhicule automobile électrique ou hybride comprend un système de motorisation électrique, alimenté par une batterie d'alimentation haute tension via un réseau électrique embarqué haute tension et divers équipements électriques auxiliaires, alimentés par une batterie d'alimentation basse tension via un réseau électrique embarqué basse tension.

**ETAT DE LA TECHNIQUE**

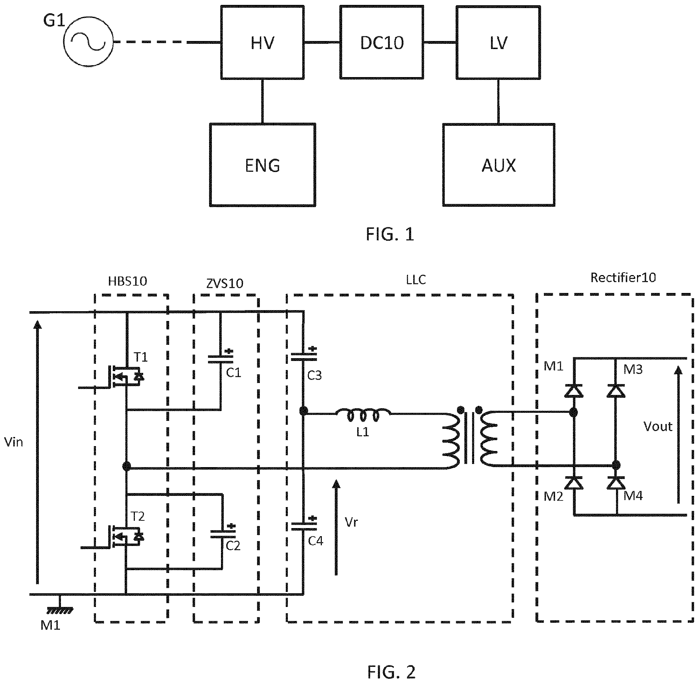

La figure 1 représente un schéma bloc fonctionnel d'un système électrique embarqué de l'état de l'art. Ainsi, la batterie d'alimentation haute tension HV assure une fonction d'alimentation en énergie du système de motorisation électrique ENG permettant la propulsion du véhicule. La batterie d'alimentation basse tension LV alimente des équipements électriques auxiliaires AUX, tels que des calculateurs embarqués, des moteurs de lève-vitres, un système multimédia, etc. La batterie d'alimentation haute tension HV délivre typiquement une tension comprise entre 100 V et 900 V, de préférence entre 100 V et 500 V, tandis que la batterie d'alimentation basse tension LV délivre typiquement une tension de l'ordre de 12 V, 24 V ou 48 V. Ces deux batteries d'alimentation haute et basse tension, HV et LV, doivent pouvoir être chargées.

La recharge en énergie électrique de la batterie d'alimentation haute tension HV est réalisée de manière connue en la connectant, via un chargeur électrique du véhicule, à un réseau d'alimentation électrique externe, par exemple le réseau électrique alternatif domestique G1. Enfin, toujours en référence à la figure 1, la charge de la batterie d'alimentation basse tension LV est réalisée de manière connue par la batterie d'alimentation haute tension HV. Le système comprend à cette fin un convertisseur continu-continu DC10.

Typiquement, le chargeur électrique comprend un convertisseur continu-continu isolé. On connait un convertisseur LLC résonant illustré en figure 2, comprenant deux capacités de résonance C3, C4, une bobine de résonance L1 et un transformateur. Dans le cas où la puissance de sortie du circuit augmente, le courant de résonance du transformateur augmente aussi et enfin, l'amplitude de la tension Vr aux bornes de chaque capacité de résonance C3, C4 augmente. Lorsque les variations d'amplitude de tension Vr sont trop importantes, elles peuvent provoquer des surcharges dans les capacités de résonance C3 et C4 et à la sortie du circuit. A titre d'exemple, les documents US 2015/229225 A1 et US 2014/268907 A1 décrivent un tel convertisseur continu-continu résonant comprenant deux capacités de résonance, une bobine de résonance, et un transformateur. Les documents précédemment cités ne proposent cependant pas de solution de protection contre une éventuelle surcharge des capacités de résonance.

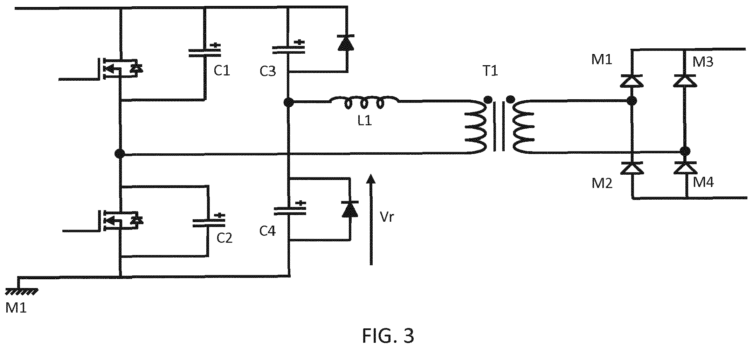

De manière connue, en référence à la figure 3, pour éviter une potentielle détérioration du circuit suite à une surcharge, il faut protéger les capacités de résonance C3 et C4 en limitant la tension à leurs bornes respectives. Pour cela, une première solution consiste à placer des diodes « ultra rapides », désignant des diodes qui commutent à très haute fréquence comme dans le cas présent, à plus de 275 kHz, en parallèle des capacités de résonance C3 et C4. Ainsi, lorsque la tension Vr est positive, la diode est bloquante, mais quand la tension Vr est négative, la diode est passante et court-circuite la capacité. Ceci modifie la structure du circuit, qui n'est donc plus un circuit LLC et ne fonctionne plus comme tel, empêchant ainsi la surcharge des capacités de résonance C3 et C4.

Cette solution présente des inconvénients, notamment le coût élevé de ces diodes « ultra rapides », sachant qu'il en faut deux par circuit. Par ailleurs, les deux diodes « ultra rapides » ne peuvent pas court-circuiter en même temps. Enfin, la tension de seuil de court-circuitage par la diode n'est pas réglable puisqu'elle est intrinsèque à la diode.

En réponse à ces inconvénients, le document EP 3588719 décrit un convertisseur de tension continu-continu comprenant un convertisseur LLC résonant comprenant une inductance de résonance, deux capacités de résonnance, et un transformateur. Le document EP 3588719 propose une solution de détection de surcharge des capacités de résonance basée sur une mesure d'un courant de résonance.

Pour pallier les mêmes inconvénients cités précédemment, la présente invention propose un système électrique configuré pour utiliser une méthode de détection de surcharge de la capacité de résonance, basée sur une mesure de courant.

## PRESENTATION GENERALE DE L'INVENTION

Plus précisément, l'invention vise un système électrique permettant la conversion d'une tension continue en une autre tension tel que divulgué dans la revendication indépendante 1. Ce système permet de détecter simplement et efficacement une surcharge.

Avantageusement, le convertisseur continu-continu résonant du système électrique comprend un redresseur, connecté en sortie du transformateur, notamment au niveau du secondaire du transformateur.
Ledit redresseur permet de convertir la tension alternative carrée, en sortie du transformateur, en une tension redressée puisée, c'est-à-dire une tension variable mais de signe constant.

De préférence, la durée d'évaluation est égale à une ou plusieurs périodes de commutation des transistors du convertisseur continu-continu résonant.

De manière préférée, le premier module de détermination est configuré pour déterminer la valeur moyenne du courant de sortie, à partir d'un point de mesure situé à une borne de sortie du redresseur, notamment une borne basse de sortie du redresseur.

De préférence, le deuxième module de détermination du système électrique est configuré pour déterminer la valeur maximale de tension et la valeur minimale de tension à partir de la tension d'entrée du convertisseur continu-continu résonant, la valeur efficace du courant de résonance, la fréquence de commutation du convertisseur continu-continu résonant et la valeur de la capacité de résonance.
La valeur maximale de tension et valeur minimale de tension sont ainsi déterminées précisément.

Avantageusement, le système électrique comprend un filtre connecté en sortie du redresseur du convertisseur continu-continu résonant.
Le filtre permet d'améliorer la qualité du signal en sortie du convertisseur continu-continu.

De manière avantageuse, le module de comparaison du système électrique est configuré de sorte que :

ledit seuil maximal de tension, correspond à une valeur maximale de tension autorisée aux bornes de la capacité de résonance, notamment au-dessus de laquelle ladite capacité est en surcharge, et
ledit seuil minimal de tension, correspond à une valeur minimale de tension autorisée aux bornes de la capacité de résonance, notamment en dessous de laquelle ladite capacité de résonance est en surcharge.

Le seuil maximal de tension et le seuil minimal de tension sont modifiables, permettant ainsi d'être adaptés en fonction du contexte du système.

Avantageusement, l'élément de détection de défaillance du système électrique comprend un élément de coupure configuré pour arrêter le fonctionnement du convertisseur continu-continu résonant en cas de défaillance.

L'invention concerne également un procédé de détection d'une surcharge d'un convertisseur continu-continu résonant tel que divulgué dans la revendication indépendante 8.

De manière préférée, l'étape de détection d'une défaillance du procédé correspond à la détection d'une surcharge d'une capacité de résonance.

Avantageusement, le procédé comprend, après l'étape de détection d'une défaillance, une étape de coupure du convertisseur continu-continu résonant, dans laquelle le fonctionnement du convertisseur continu-continu résonant est arrêté.

Le procédé permet de protéger le système électrique, en particulier le convertisseur continu-continu, afin d'éviter une détérioration possible de certains composants du système, notamment des capacités de résonance, et donc d'éviter un fonctionnement erroné du système.

De manière préférée, la valeur maximale de la tension aux bornes de chaque capacité de résonance est déterminée suivant la formule :

$$V_{r\_max} = \frac{1}{2}V_{in} + \frac{\sqrt{2}}{C_r 2\pi F_s}\sqrt{(N \times I_{s\_avg} \times \frac{\pi}{2\sqrt{2}})^2 + (\frac{V_{out}}{4\sqrt{3} \times N \times F_s \times L_m})^2}$$

et la valeur minimale ($V_{r\_min}$) de la tension aux bornes de chaque capacité de résonance (Cr/2) est déterminée suivant la formule:

$$V_{r\_min} = \frac{1}{2}V_{in} - \frac{\sqrt{2}}{C_r 2\pi F_s}\sqrt{(N \times I_{s\_avg} \times \frac{\pi}{2\sqrt{2}})^2 + (\frac{V_{out}}{4\sqrt{3} \times N \times F_s \times L_m})^2}$$

où $V_{in}$ est la tension d'entrée du convertisseur continu-continu résonant, $C_r$ est la valeur des capacités de résonance, $F_s$ est la fréquence de commutation du convertisseur continu-continu résonant, N désigne le rapport de transformation du transformateur, $I_{s\_avrg}$ est la valeur moyenne du courant de sortie, $V_{out}$ est la tension de sortie et $L_m$ désigne l'inductance magnétisante primaire du transformateur.

## DESCRIPTION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :

- la figure 1 (déjà commentée), le schéma bloc fonctionnel d'un système électrique selon l'état de l'art ;
- la figure 2 (déjà commentée), un schéma électronique d'un système électrique selon l'état de l'art ;
- la figure 3 (déjà commentée), un schéma électronique d'un système électrique selon l'état de l'art ;
- la figure 4, le schéma bloc fonctionnel d'un système électrique selon l'invention,
- la figure 5, le schéma électronique du système électrique de la figure 4,
- la figure 6, un schéma bloc représentant le procédé de détection de surcharge selon l'invention.

Il faut noter que les figures exposent l'invention de manière détaillée pour mettre en œuvre l'invention, lesdites figures pouvant bien entendu servir à mieux définir l'invention le cas échéant.

## DESCRIPTION DETAILLEE DE L'INVENTION

Il est rappelé que la présente invention est décrite ci-après à l'aide de différents modes de réalisation non limitatifs et est susceptible d'être mise en œuvre dans des variantes à la portée de l'homme du métier, également visées par la présente invention.

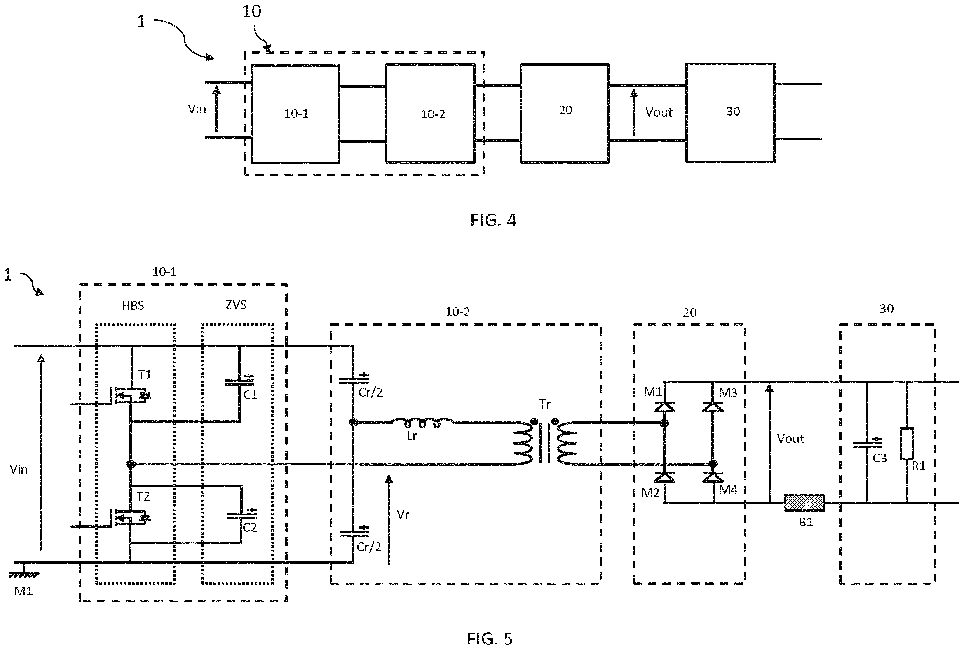

La figure 4 représente un schéma bloc fonctionnel d'une forme de réalisation du système électrique selon l'invention. Ce système électrique est notamment destiné à être monté dans un véhicule automobile électrique ou hybride. L'invention concerne un convertisseur continu-continu résonant 1.

En référence à la figure 4, le système électrique comprend un convertisseur continu-continu résonant 1, comprenant un circuit convertisseur 10, un redresseur 20, connecté en sortie dudit circuit convertisseur 10, et un filtre 30, connecté en sortie dudit redresseur 20. Le filtre 30 peut être omis. Le convertisseur continu-continu résonant 1 permet de convertir une tension continue en une autre tension continue, la topologie détaillée de ce convertisseur sera décrite en détails dans une prochaine partie. Le circuit convertisseur 10, comprend un premier circuit 10-1 et un deuxième circuit 10-2, permettant d'obtenir notamment une tension alternative carrée, autrement dit un courant sinusoïdal, à partir d'une tension continue. Le redresseur 20 permet de convertir une tension alternative carrée en une tension redressée puisée, c'est-à-dire une tension variable mais de signe constant. Le filtre 30 permet de « lisser » la tension obtenue précédemment, c'est-à-dire obtenir en sortie du filtre 30 la valeur moyenne de la tension d'entrée du filtre 30.

La figure 5 représente la topologie détaillée du système électrique présenté à la figure 4, c'est-à-dire d'un convertisseur continu-continu résonant 1. Dans ce mode de réalisation détaillé, le premier circuit 10-1 du circuit convertisseur 10 du convertisseur continu-continu résonant 1 comprend un circuit dit « HBS », de l'anglais « Half Bridge switches ». Par ailleurs, le deuxième circuit 10-2 du circuit convertisseur 10, relié au premier circuit 10-1, comprend un circuit convertisseur LLC résonant, dont la structure est connue de l'homme du métier.

Le circuit HBS comprend deux transistors T1 et T2, notamment des transistors à effet de champ, et assure une fonction d'alimentation à découpage, grâce aux transistors T1, T2 fonctionnant en commutation. Des pertes peuvent se produire lors de l'activation et de la désactivation de chaque transistor T1, T2. Des capacités C1, C2 peuvent être connectées respectivement en parallèle des transistors T1, T2 pour permettre des commutations à zéro de tension ou ZVS (pour « Zero Voltage Switching » en anglais), et de minimiser les pertes dues à la commutation et ainsi d'obtenir une fréquence de commutation plus élevée pour les transistors T1 et T2. Toujours en référence à la figure 5, le convertisseur LLC résonant du deuxième circuit 10-2, comprend une inductance de résonance $L_r$, deux capacités de résonance Cr/2, dont une première capacité est connectée avec une borne haute du premier circuit 10-1 et une deuxième capacité connectée à une borne basse du premier circuit 10-1, les deux capacités de résonance Cr/2 étant connectées à leur autre borne au niveau d'un point milieu, et un transformateur Tr, qui présente une inductance magnétisante au primaire.

Le redresseur 20 peut être un pont de quatre diodes pour permettre le redressement de tension. En effet, une tension alternative carrée, passant du positif au négatif, est redressée en une tension périodique de signe constant, soit positif, soit négatif.

Par ailleurs, toujours en référence à la figure 5, le filtre 30 peut comprendre une résistance R1 et une capacité C3 montées en parallèle, ou simplement une capacité montée en parallèle du redresseur 20 ou encore un filtre LC.

Lorsque la tension d'entrée du filtre 30, correspondant à la tension de sortie du redresseur 20, augmente, la capacité C3 se charge. Puis, lorsque la tension d'entrée du filtre 30 diminue, la capacité C3 se décharge. Mais, de manière connue, une capacité se charge et se décharge « lentement » et donc l'amplitude de la tension délivrée en sortie du filtre 30 est beaucoup plus faible que celle de la tension d'entrée du filtre 30, voire presque nulle. Ainsi, la tension en sortie du filtre 30 est quasiment continue.

La détection d'une potentielle surcharge d'une des capacités de résonance Cr/2 est obtenue à partir de la mesure du courant de sortie $I_s$ à un point de mesure B1 pris en sortie du redresseur 20.

Par ailleurs, toujours afin de détecter une potentielle surcharge d'une capacité de résonance Cr/2, le système électrique comprend une unité de commande TN. L'unité de commande TN est notamment un dispositif de traitement numérique. Ladite unité de commande TN comprend un premier module de détermination TN1, un deuxième module de détermination TN2, comprenant un module de comparaison TNC, et un élément de détection de défaillance UP. L'unité de commande TN est notamment reliée par son premier module de détermination TN1 au point de mesure B1. L'élément de détection de défaillance UP peut être une unité de pilotage des transistors, communément appelé « driver » par l'homme du métier.

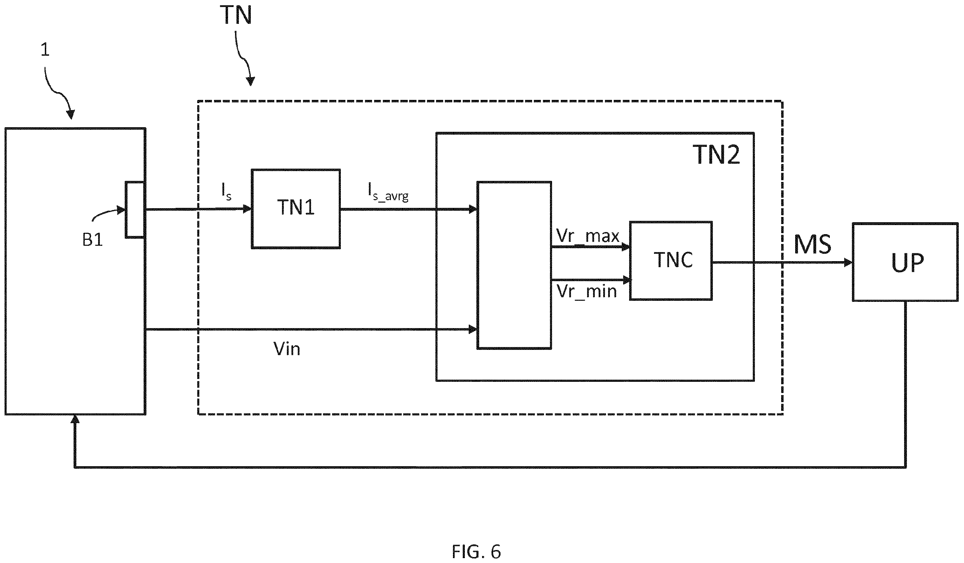

En référence à la figure 6, il est représenté un mode de réalisation du procédé de détection d'une surcharge d'un convertisseur continu-continu résonant 1.

**Etape 1 : détermination de la valeur du courant de résonance efficace** $I_{r\_RMS}$

Le premier module de détermination TN1 détermine la valeur moyenne $I_{s\_avg}$ du courant de sortie $I_s$, mesuré sur un point de mesure B1 pris en borne basse en sortie du redresseur 20 du convertisseur continu-continu résonant 1, sur une durée T dite « durée d'évaluation ». Cette durée d'évaluation T peut s'étendre sur une ou plusieurs périodes de commutation des transistors T1, T2 et peut comprendre une portion d'une période de commutation.

La valeur moyenne $I_{s\_avg}$ du courant de sortie $I_s$ est également liée à la valeur efficace du courant de résonance $I_{r\_RMS}$.

En effet, en appliquant la loi des nœuds au nœud situé à la borne basse de l'inductance magnétisante primaire du transformateur Tr, la valeur efficace du courant de résonance $I_{r\_RMS}$ est définie selon la formule suivante :

$$I_{r\_RMS} \approx \sqrt{I_s{}^2 + I_m{}^2} \qquad (1)$$

Pour rappel, $I_s$ désigne la mesure du courant de sortie et $I_m$ désigne le courant traversant l'inductance magnétisante primaire du transformateur Tr.

Ensuite, lorsqu'on remplace les valeurs du courant de sortie $I_s$ et du courant traversant l'inductance magnétisante primaire $I_m$ par leurs expressions respectives, dans l'expression (1), on obtient l'expression suivante :

$$I_{r\_RMS} \approx \sqrt{(N \times I_{s\_RMS})^2 + (\frac{V_{out}}{4\sqrt{3} \times N \times F_s \times L_m})^2} \qquad (1bis)$$

Pour rappel, N désigne le rapport de transformation du transformateur Tr défini mathématiquement par le rapport du nombre de spires de l'inductance secondaire sur le nombre de spires de l'inductance primaire du transformateur Tr. De plus, $L_m$ désigne l'inductance magnétisante primaire du transformateur Tr, $V_{out}$ désigne la tension de sortie du redresseur 20, $F_s$ désigne la fréquence de commutation du convertisseur continu-continu résonant 1, et donc dans le cas présent la fréquence de commutation des transistors T1, T2 et $I_{s\_RMS}$ définit la valeur efficace du courant de sortie.

Par ailleurs, il est connu que la valeur efficace du courant de sortie $I_{s\_RMS}$ est définie selon la formule suivante :

$I_{s\_RMS} = I_{s\_avg} \times \frac{\pi}{2\sqrt{2}}$ . Ainsi, si on remplace dans (1bis) la valeur efficace du courant de sortie $I_{s\_RMS}$ par son expression, on obtient :

$$I_{r\_RMS} \approx \sqrt{(N \times I_{s\_avg} \times \frac{\pi}{2\sqrt{2}})^2 + (\frac{V_{out}}{4\sqrt{3} \times N \times F_s \times L_m})^2} \qquad (1ter)$$

Ainsi, l'équation (1ter) démontre que la valeur moyenne $I_{s\_avg}$ du courant de sortie $I_s$, déterminée par le premier module de détermination TN1, est mathématiquement liée à la valeur efficace du courant de résonance $I_{r\_RMS}$.

**Etape 2 : détermination de $V_{r\_max}$ et $V_{r\_min}$**

Le deuxième module de détermination TN2 détermine la valeur maximale $V_{r\_max}$ de la tension aux bornes de chaque capacité de résonance Cr/2 et la valeur minimale $V_{r\_min}$ de la tension aux bornes de chaque capacité de résonance Cr/2 à partir de la valeur moyenne $I_{s\_avg}$ du courant de sortie $I_s$, déterminée précédemment, et de la tension (2) d'entrée $V_{in}$. Pour cela, ledit deuxième module de détermination TN2 utilise l'expression d'une tension dans une capacité de résonance. La tension $V_r$ sinusoïdale aux bornes de chaque capacité de résonance Cr/2 est définie par la formule suivante :

$$V_r(t) = \frac{1}{2}V_{in} + U_0 \cos(2\pi F_s t).$$

Dans cette équation, $V_{in}$ désigne la mesure de la tension d'entrée du convertisseur continu-continu résonant 1, $U_0$ est une constante, notamment représentative de l'amplitude de la tension $V_r$ périodique, $F_s$ désigne, comme précédemment, la fréquence de commutation des transistors T1, T2 et enfin, t représente le temps. On a deux capacités de résonance Cr/2 identiques, dont une première capacité connectée à une borne haute du premier circuit 10-1 et une deuxième capacité connectée à une borne basse du premier circuit 10-1, les deux capacités étant connectées à leur autre borne au niveau d'un point milieu. Le circuit convertisseur LLC résonant est notamment connecté d'une part au point milieu des capacités de résonance Cr/2 et d'autre part au point milieu des transistors T1, T2. Selon une analyse par modèles petits signaux on considère que ces capacités sont montées en parallèle.

D'autre part, on connaît l'expression du courant dans une capacité, et donc ici dans les capacités de résonance Cr/2, et l'expression du courant de résonance $I_r$ :

$$\frac{1}{2}C_r\frac{dV_r(t)}{dt} = \frac{1}{2}I_r(t) \qquad (3)$$

et

$$I_r(t) = I_{r\_peak}\sin(2\pi F_s t) \qquad (4)$$

où $I_{r\_peak}$ est la valeur maximale du courant de résonance Ir. Dans (3), en remplaçant $I_r(t)$ par son expression donnée en (4), on obtient :

$$\frac{1}{2}C_r\frac{dV_r(t)}{dt} = \frac{1}{2}I_{r\_peak}\sin(2\pi F_s t) \qquad (3bis)$$

Dans l'équation (3bis) on remplace la tension Vr par son expression dans (2). On obtient ainsi :

$$\frac{1}{2}C_r\frac{dV_r(t)}{dt} = \frac{1}{2}C_r\frac{d\left(\left(\frac{1}{2}V_{in} + U_0\cos(2\pi F_s t)\right)\right)}{dt} = \frac{1}{2}I_{r\_peak}\sin(2\pi F_s t)$$

$$-U_0 2\pi F_s Cr * \sin(2\pi F_s t)) = I_{r\_peak}\sin(2\pi F_s t)$$

On obtient donc :

$$U_0 = \frac{-I_{r\_peak}}{2\pi Cr F_s} \qquad (5)$$

En remplaçant $U_0$ dans (1) par son expression dans (4), on obtient :

$$V_r(t) = \frac{1}{2}V_{in} - \frac{I_{r\_peak}}{2\pi C_r F_s} * \cos(2\pi F_s t) \qquad\qquad (2bis)$$

Rappelons que $I_{r\_peak} = \sqrt{2}\, I_{r\_RMS}$, ainsi, dans (2bis), en remplaçant $I_{r\_peak}$ par son expression, on trouve :

$$V_r(t) = \frac{1}{2}V_{in} - \frac{\sqrt{2}\, I_{r\_RMS}}{C_r 2\pi F_s} \cos(2\pi F_s t) \qquad\qquad (2ter)$$

On sait que $V_{in}$ et $\frac{\sqrt{2}\, I_{r\_RMS}}{C_r 2\pi F_s}$ sont des valeurs constantes. Le seul membre variable de l'expression (2ter) de la tension $V_r$ est le $\cos(2\pi F_s t)$. Ainsi, le maximum d'un $\cos(2\pi F_s t)$ étant égal à 1 et le minimum d'un $\cos(2\pi F_s t)$ étant égal à -1, on en déduit la valeur maximale $V_{r\_max}$ de la tension Vr et la valeur minimale $V_{r\_min}$ de la tension Vr :

$$V_{r\_max} = \frac{1}{2}V_{in} + \frac{\sqrt{2}\, I_{r\_RMS}}{C_r 2\pi F_s}$$

$$V_{r\_min} = \frac{1}{2}V_{in} - \frac{\sqrt{2}\, I_{r\_RMS}}{C_r 2\pi F_s}$$

On obtient les expressions de la valeur maximale $V_{r\_max}$ et de la valeur minimale $V_{r\_min}$ en fonction de la valeur efficace du courant de résonance $I_{r\_RMS}$.

Par ailleurs, l'expression de la valeur efficace du courant de résonance $I_{r\_RMS}$ en fonction de la valeur moyenne $I_{s\_avg}$ du courant de sortie $I_s$ a été précédemment déterminée dans l'équation (1ter). Ainsi, dans les expressions de la valeur maximale $V_{r\_max}$ et de la valeur minimale $V_{r\_min}$ on peut remplacer la valeur efficace du courant de résonance $I_{r\_RMS}$ par son expression donnée dans l'équation (1ter). On obtient :

$$V_{r\_max} = \frac{1}{2}V_{in} + \frac{\sqrt{2}}{C_r 2\pi F_s}\sqrt{(N \times I_{s\_avg} \times \frac{\pi}{2\sqrt{2}})^2 + (\frac{V_{out}}{4\sqrt{3} \times N \times F_s \times L_m})^2}$$

$$V_{r\_min} = \frac{1}{2}V_{in} - \frac{\sqrt{2}}{C_r 2\pi F_s}\sqrt{(N \times I_{s\_avg} \times \frac{\pi}{2\sqrt{2}})^2 + (\frac{V_{out}}{4\sqrt{3} \times N \times F_s \times L_m})^2}$$

**Etape 3 : comparaison entre seuils et $V_{r\_min}$ et $V_{r\_max}$**

Toujours en référence à la figure 6, le deuxième module de détermination TN2 comprend également un module de comparaison TNC, qui réalise la comparaison d'une part entre un seuil maximal de tension $V_{r\_define\_max}$ et la valeur maximale $V_{r\_max}$ et d'autre part entre un seuil minimal de tension $V_{r\_define\_min}$ et la valeur minimale $V_{r\_min}$. Ledit seuil maximal de tension $V_{r\_define\_max}$ est notamment défini comme la valeur de tension maximale aux bornes de la capacité de résonance Cr/2, au-dessus de laquelle ladite capacité est en surcharge. Par ailleurs, ledit seuil minimal de tension $V_{r\_define\_min}$, est notamment défini comme la valeur de tension minimale aux bornes de la capacité de résonance Cr/2 en dessous de laquelle, ladite capacité de résonance est en surcharge.

Ainsi, la détection d'une défaillance du convertisseur de tension continu-continu résonant 1 se fait lorsque la valeur maximale $V_{r\_max}$ de tension est supérieure ou égale au seuil maximal de tension $V_{r\_define\_max}$ et/ou lorsque la valeur minimale $V_{r\_min}$ de tension est inférieure ou égale au seuil minimal de tension $V_{r\_define\_min}$. L'étape de détection de défaillance correspond dans le cas présent à la détection d'une surcharge d'une capacité de résonance Cr/2.

Toujours en référence à la figure 6, lorsqu'il y a détection d'une défaillance, s'en suit une étape de coupure du convertisseur continu-continu résonant 1 qui stoppe le fonctionnement du convertisseur continu-continu résonant 1. Pour cela, l'élément de détection de défaillance UP comprend un élément de coupure configuré pour arrêter le fonctionnement du convertisseur continu-continu résonant 1 en cas de défaillance. Ainsi, le module de de comparaison TNC envoie un message d'arrêt MS à l'élément de coupure de l'élément de détection de défaillance UP du convertisseur continu-continu résonant 1. L'élément de coupure reçoit ledit message d'arrêt MS, contenant une commande d'arrêt, envoyé précédemment. Après la réception de ce message d'arrêt MS, l'élément de coupure arrête le fonctionnement du convertisseur continu-continu résonant 1, protégeant ainsi le convertisseur continu-continu résonant 1 d'une détérioration de ses composants, ladite détérioration étant due à une surcharge.

Une alternative possible à l'étape de coupure du convertisseur continu-continu résonant 1 consiste en une étape dans laquelle l'élément de détection de défaillance UP imposerait au convertisseur continu-continu résonant 1 de fonctionner en mode dégradé sans imposer un arrêt complet du convertisseur continu-continu résonant 1.

## Revendications

1. Système électrique permettant la conversion d'une tension continue en une autre tension continue, comprenant :

   - un convertisseur continu-continu résonant (1) comprenant un circuit convertisseur LLC résonant comprenant une inductance de résonance (L), deux capacités de résonance (Cr/2) et un transformateur (Tr),
   - une unité de commande (TN) comprenant :

     ◦ un premier module de détermination (TN1) de la valeur moyenne ($I_{s\_avg}$) du courant de sortie ($I_s$) du convertisseur continu-continu résonant (1) sur une durée (T) dite « durée d'évaluation », **caractérisé en ce que** l'unité de commande comprend également :

       ◦ un deuxième module de détermination (TN2) d'une valeur maximale ($V_{r\_max}$) de la tension aux bornes de chaque capacité de résonance (Cr/2) et d'une valeur minimale ($V_{r\_min}$) de la tension aux bornes de chaque capacité de résonance (Cr/2) sur la durée d'évaluation, à partir de la valeur moyenne ($I_{s\_avg}$) du courant de sortie ($I_s$) en exprimant la valeur maximale ($V_{r\_max}$) et la valeur minimale ($V_{r\_min}$) de la tension aux bornes de chaque capacité de résonance (Cr/2) en fonction de la valeur efficace du courant de résonance ($I_{r\_RMS}$), la valeur efficace du courant de résonance ($I_{r\_RMS}$) étant exprimée en fonction de la valeur moyenne ($I_{s\_avg}$) du courant de sortie ($I_s$),
       ◦ un module de comparaison (TNC) entre un seuil maximal de tension ($V_{r\_define\_max}$) et la valeur maximale ($V_{r\_max}$) de la tension aux bornes de chaque capacité de résonance (Cr/2) et entre un seuil minimal de tension ($V_{r\_define\_min}$) et la valeur minimale ($V_{r\_min}$) de la tension aux bornes de chaque capacité de résonance (Cr/2),
       ◦ un élément de détection de défaillance (UP) configuré pour détecter une défaillance du convertisseur continu-continu résonant (1) si :

         ▪ ladite valeur maximale de tension ($V_{r\_max}$) est supérieure ou égale au seuil maximal de tension ($V_{r\_define\_max}$), ou
         ▪ ladite valeur minimale de tension ($V_{r\_min}$) est inférieure ou égale au seuil minimal de tension ($V_{r\_define\_min}$).

2. Système électrique selon la revendication précédente, dans lequel le convertisseur continu-continu résonant (1) comprend un redresseur (20), connecté au niveau du secondaire du transformateur (Tr).

3. Système électrique, selon la revendication précédente, dans lequel le premier module de détermination (TN1) est configuré pour déterminer la valeur moyenne ($I_{s\_avg}$) du courant de sortie ($I_s$), à partir d'un point de mesure situé à une borne de sortie du redresseur (20), notamment une borne basse de sortie du redresseur (20).

4. Système électrique selon l'une des revendications précédentes, dans lequel le deuxième module de détermination (TN2) est configuré pour déterminer la valeur maximale de tension ($V_{r\_max}$) et la valeur minimale de tension ($V_{r\_min}$) à partir de : la tension d'entrée ($V_{in}$) du convertisseur continu-continu résonant (1), la valeur moyenne ($I_{s\_avg}$) du courant de sortie ($I_s$),la fréquence de commutation ($F_s$) du convertisseur continu-continu résonant (1), la valeur de la capacité de résonance (Cr), la valeur de la tension de sortie $V_{out}$ du redresseur (20), le rapport de transformation (N) du transformateur (Tr) et l'inductance magnétisante primaire ($L_m$) du transformateur (Tr).

**5.** Système électrique selon l'une des revendications précédentes, comprenant un filtre (30), connecté en sortie du redresseur du convertisseur continu-continu résonant (1).

**6.** Système électrique selon l'une des revendications précédentes, dans lequel le module de comparaison (TNC) est configuré de sorte que

ledit seuil maximal de tension ($V_{r\_define\_max}$), correspond à une valeur maximale de tension autorisée aux bornes de la capacité de résonance, notamment au-dessus de laquelle ladite capacité est en surcharge, et

ledit seuil minimal de tension ($V_{r\_define\_min}$), correspond à une valeur minimale de tension autorisée aux bornes de la capacité de résonance, notamment en dessous de laquelle ladite capacité de résonance est en surcharge.

**7.** Système électrique selon l'une des revendications précédentes, dans lequel l'élément de détection de défaillance (UP) comprend un élément de coupure configuré pour arrêter le fonctionnement du convertisseur continu-continu résonant (1) en cas de défaillance.

**8.** Procédé de détection d'une surcharge d'un convertisseur continu-continu résonant (1) mis en œuvre dans un système électrique comportant un convertisseur continu-continu résonant (1) comprenant un circuit convertisseur LLC résonant qui comprend une inductance de résonance (L), deux capacités de résonance (Cr/2) et un transformateur (Tr),

ledit procédé étant **caractérisé en ce qu'**il comprend des étapes de :

• détermination, notamment de mesure, du courant de sortie ($I_s$),
• détermination de la valeur moyenne ($I_{s\_avg}$) dudit courant de sortie ($I_s$) , sur

une durée (T) dite « durée d'évaluation », **caractérisé en ce que** le procédé comprend également les étapes de :

• détermination d'une valeur maximale ($V_{r\_max}$) de la tension aux bornes de chaque capacité de résonance (Cr/2) et d'une valeur minimale ($V_{r\_min}$) de la tension aux bornes de chaque capacité de résonance (Cr/2), sur la durée dévaluation « T », à partir de la valeur moyenne ($I_{s\_avg}$) du courant de sortie ($I_s$), déterminée à l'étape précédente, en exprimant la valeur maximale ($V_{r\_max}$) et la valeur minimale ($V_{r\_min}$) de la tension aux bornes de chaque capacité de résonance (Cr/2) en fonction de la valeur efficace du courant de résonance ($I_{r\_RMS}$), la valeur efficace du courant de résonance ($I_{r\text{-}RMS}$) étant exprimée en fonction de la valeur moyenne ($I_{s\_avg}$) du courant de sortie ($I_s$),
• comparaison entre un seuil maximal de tension ($V_{r\_define\_max}$) et la valeur maximale ($V_{r\_max}$) de la tension aux bornes de chaque capacité de résonance (Cr/2) et entre un seuil minimal de tension ($V_{r\_define\_min}$) et la valeur minimale ($V_{r\_min}$) de la tension aux bornes de chaque capacité de résonance (Cr/2),
• détection d'une défaillance du convertisseur de tension continu-continu résonant (1)si ladite valeur maximale de tension ($V_{r\_max}$) est supérieure ou égale au seuil maximal de tension ($V_{r\_define\_max}$), et/ou si ladite valeur minimale de tension ($V_{r\_min}$) est inférieure ou égale au seuil minimal de tension ($V_{r\_define\_min}$).

**9.** Procédé selon la revendication précédente, dans lequel l'étape de détection de défaillance correspond à la détection d'une surcharge d'une capacité de résonance (Cr/2).

**10.** Procédé selon la revendication 8 ou 9, comprenant, après l'étape de détection d'une défaillance, une étape de coupure du convertisseur continu-continu résonant (1), dans laquelle le fonctionnement du convertisseur continu-continu résonant (1) est arrêté.

**11.** Procédé selon l'une des revendications 8 à 10, dans lequel la valeur maximale ($V_{r\_max}$) de la tension aux bornes de chaque capacité de résonance (Cr/2) est déterminée suivant la formule :

$$V_{r\_max} = \frac{1}{2}V_{in} + \frac{\sqrt{2}}{C_r 2\pi F_s}\sqrt{(N \times I_{s\_avg} \times \frac{\pi}{2\sqrt{2}})^2 + (\frac{V_{out}}{4\sqrt{3} \times N \times F_s \times L_m})^2}$$

et la valeur minimale ($V_{r\_min}$) de la tension aux bornes de chaque capacité de résonance (Cr/2) est déterminée suivant la formule:

$$V_{r\_min} = \frac{1}{2}V_{in} - \frac{\sqrt{2}}{C_r 2\pi F_s}\sqrt{(N \times I_{s\_avg} \times \frac{\pi}{2\sqrt{2}})^2 + (\frac{V_{out}}{4\sqrt{3} \times N \times F_s \times L_m})^2}$$

où $V_{in}$ est la tension d'entrée du convertisseur continu-continu résonant (1), $C_r$ est la valeur des capacités de résonance (Cr/2), $F_s$ est la fréquence de commutation du convertisseur continu-continu résonant (1), N désigne le rapport de transformation du transformateur (Tr), $I_{s\_avrg}$ est la valeur moyenne du courant de sortie ($I_s$), $V_{out}$ est la tension de sortie et $L_m$ désigne l'inductance magnétisante primaire du transformateur (Tr).

## Patentansprüche

1. Elektrisches System, das die Umwandlung einer Gleichspannung in eine andere Gleichspannung ermöglicht, das enthält:

   • einen Gleichstrom-Gleichstrom-Resonanzwandler (1), der eine Resonanzwandlerschaltung LLC enthält, die eine Resonanzinduktivität (L), zwei Resonanzkapazitäten (Cr/2) und einen Transformator (Tr) enthält,
   • eine Steuereinheit (TN), die enthält:

      ◦ ein erstes Bestimmungsmodul (TN1) des Mittelwerts ($I_{s\_avg}$) des Ausgangsstroms ($I_s$) des Gleichstrom-Gleichstrom-Resonanzwandlers (1) über einen "Bewertungszeitraum" genannten Zeitraum (T),

   **dadurch gekennzeichnet, dass** die Steuereinheit ebenfalls enthält:

      ◦ ein zweites Bestimmungsmodul (TN2) eines maximalen Werts ($V_{r\_max}$) der Spannung an den Klemmen jeder Resonanzkapazität (Cr/2) und eines minimalen Werts ($V_{r\_min}$) der Spannung an den Klemmen jeder Resonanzkapazität (Cr/2) über den Bewertungszeitraum, ausgehend vom Mittelwert ($I_{s\_avg}$) des Ausgangsstroms ($I_s$), indem der maximale Wert ($V_{r\_max}$) und der minimale Wert ($V_{r\_min}$) der Spannung an den Klemmen jeder Resonanzkapazität (Cr/2) abhängig vom Effektivwert des Resonanzstroms ($I_{r\_RMS}$) ausgedrückt werden, wobei der Effektivwert des Resonanzstroms ($I_{r\_RMS}$) abhängig vom Mittelwert ($I_{s\_avg}$) des Ausgangsstroms ($I_s$) ausgedrückt wird,
      ◦ ein Vergleichsmodul (TNC) zwischen einer maximalen Spannungsschwelle ($V_{r\_define\_max}$) und dem maximalen Wert ($V_{r\_max}$) der Spannung an den Klemmen jeder Resonanzkapazität (Cr/2) und zwischen einer minimalen Spannungsschwelle ($V_{r\_define\_min}$) und dem minimalen Wert ($V_{r\_min}$) der Spannung an den Klemmen jeder Resonanzkapazität (Cr/2),
      ◦ ein Ausfallerfassungselement (UP), das konfiguriert ist, einen Ausfall des Gleichstrom-Gleichstrom-Resonanzwandlers (1) zu erfassen, wenn:

         • der maximale Spannungswert ($V_{r\_max}$) höher als die oder gleich der maximalen Spannungsschwelle ($V_{r\_define\_max}$) ist, oder
         • der minimale Spannungswert ($V_{r\_min}$) niedriger als die oder gleich der minimalen Spannungsschwelle ($V_{r\_define\_min}$) ist.

2. Elektrisches System nach dem vorhergehenden Anspruch, wobei der Gleichstrom-Gleichstrom-Resonanzwandler (1) einen im Bereich der Sekundärseite des Transformators (Tr) verbundenen Gleichrichter (20) enthält.

3. Elektrisches System nach dem vorhergehenden Anspruch, wobei das erste Bestimmungsmodul (TN1) konfiguriert ist, den Mittelwert ($I_{s\_avg}$) des Ausgangsstroms ($I_s$) ausgehend von einem Messpunkt zu bestimmen, der sich an einer Ausgangsklemme des Gleichrichters (20), insbesondere einer niederen Ausgangsklemme des Gleichrichters (20) befindet.

4. Elektrisches System nach einem der vorhergehenden Ansprüche, wobei das zweite Bestimmungsmodul (TN2) konfiguriert ist, den maximalen Spannungswert ($V_{r\_max}$) und den minimalen Spannungswert ($V_{r\_min}$) ausgehend von: der Eingangsspannung ($V_{in}$) des Gleichstrom-Gleichstrom-Resonanzwandlers (1), dem Mittelwert ($I_{s\_avg}$) des Ausgangsstroms ($I_s$), der Schaltfrequenz ($F_s$) des Gleichstrom-Gleichstrom-Resonanzwandlers (1), dem Wert der Resonanzkapazität (Cr), dem Wert der Ausgangsspannung $V_{out}$ des Gleichrichters (20), dem Wandlungsverhältnis (N) des Transformators (Tr) und der primären Magnetisierungsinduktivität ($L_m$) des Transformators (Tr) zu bestimmen.

**5.** Elektrisches System nach einem der vorhergehenden Ansprüche, das einen Filter (30) enthält, der am Ausgang des Gleichrichters des Gleichstrom-Gleichstrom-Resonanzwandlers (1) verbunden ist.

**6.** Elektrisches System nach einem der vorhergehenden Ansprüche, wobei das Vergleichsmodul (TNC) so konfiguriert ist, dass

die maximale Spannungsschwelle ($V_{r\_define\_max}$) einem erlaubten maximalen Spannungswert an den Klemmen der Resonanzkapazität entspricht, insbesondere oberhalb dessen die Kapazität überlastet ist, und die minimale Spannungsschwelle ($V_{r\_define\_min}$) einem erlaubten minimalen Spannungswert an den Klemmen der Resonanzkapazität entspricht, insbesondere unterhalb dessen die Resonanzkapazität überlastet ist.

**7.** Elektrisches System nach einem der vorhergehenden Ansprüche, wobei das Ausfallerfassungselement (UP) ein Abschaltelement enthält, das konfiguriert ist, den Betrieb des Gleichstrom-Gleichstrom-Resonanzwandlers (1) bei einem Ausfall anzuhalten.

**8.** Verfahren zur Erfassung einer Überlastung eines Gleichstrom-Gleichstrom-Resonanzwandlers (1), das in einem elektrischen System angewendet wird, das einen Gleichstrom-Gleichstrom-Resonanzwandler (1) aufweist, der eine Resonanzwandlerschaltung LLC enthält, die eine Resonanzinduktivität (L), zwei Resonanzkapazitäten (Cr/2) und einen Transformator (Tr) enthält,

wobei das Verfahren **dadurch gekennzeichnet ist, dass** es folgende Schritte enthält:

• Bestimmung, insbesondere Messbestimmung, des Ausgangsstroms ($I_s$),
• Bestimmung des Mittelwerts ($I_{s\_avg}$) des Ausgangsstroms ($I_s$) über einen "Bewertungszeitraum" genannten Zeitraum (T),

**dadurch gekennzeichnet, dass** das Verfahren ebenfalls die folgenden Schritte enthält:

• Bestimmung eines maximalen Werts ($V_{r\_max}$) der Spannung an den Klemmen jeder Resonanzkapazität (Cr/2) und eines minimalen Werts ($V_{r\_min}$) der Spannung an den Klemmen jeder Resonanzkapazität (Cr/2) über den Bewertungszeitraum "T" ausgehend vom im vorhergehenden Schritt bestimmten Mittelwert ($I_{s\_avg}$) des Ausgangsstroms ($I_s$), indem der maximale Wert ($V_{r\_max}$) und der minimale Wert ($V_{r\_min}$) der Spannung an den Klemmen jeder Resonanzkapazität (Cr/2) abhängig vom Effektivwert des Resonanzstroms ($I_{r\_RMS}$) ausgedrückt werden, wobei der Effektivwert des Resonanzstroms ($I_{r\_RMS}$) abhängig vom Mittelwert ($I_{s\_avg}$) des Ausgangsstroms ($I_s$) ausgedrückt wird,
• Vergleich zwischen einer maximalen Spannungsschwelle ($V_{r\_define\_max}$) und dem maximalen Wert ($V_{r\_max}$) der Spannung an den Klemmen jeder Resonanzkapazität (Cr/2) und zwischen einer minimalen Spannungsschwelle ($V_{r\_define\_min}$) und dem minimalen Wert ($V_{r\_min}$) der Spannung an den Klemmen jeder Resonanzkapazität (Cr/2),
• Erfassung eines Ausfalls des Gleichstrom-Gleichstrom-Resonanzspannungswandlers (1), wenn der maximale Spannungswert ($V_{r\_max}$) höher als die oder gleich der maximalen Spannungsschwelle ($V_{r\_define\_max}$) ist und/oder wenn der minimale Spannungswert ($V_{r\_min}$) niedriger als die oder gleich der minimalen Spannungsschwelle ($V_{r\_define\_min}$) ist.

**9.** Verfahren nach dem vorhergehenden Anspruch, wobei der Schritt der Ausfallerfassung der Erfassung einer Überlastung einer Resonanzkapazität (Cr/2) entspricht.

**10.** Verfahren nach Anspruch 8 oder 9, das nach dem Schritt der Erfassung eines Ausfalls einen Schritt des Abschaltens des Gleichstrom-Gleichstrom-Resonanzwandlers (1) enthält, in dem der Betrieb des Gleichstrom-Gleichstrom-Resonanzwandlers (1) angehalten wird.

**11.** Verfahren nach einem der Ansprüche 8 bis 10, wobei der maximale Wert ($V_{r\_max}$) der Spannung an den Klemmen jeder Resonanzkapazität (Cr/2) gemäß der Formel:

$$V_{r\_max} = \frac{1}{2}V_{in} + \frac{\sqrt{2}}{C_r 2\pi F_s}\sqrt{\left(N \times I_{s-avg} \times \frac{\pi}{2\sqrt{2}}\right)^2 + \left(\frac{V_{out}}{4\sqrt{3} \times N \times F_s \times L_m}\right)^2}$$

bestimmt wird, und der minimale Wert ($V_{r\_min}$) der Spannung an den Klemmen jeder Resonanzkapazität (Cr/2) gemäß der Formel:

$$V_{r\_min} = \frac{1}{2}V_{in} - \frac{\sqrt{2}}{C_r 2\pi F_s}\sqrt{\left(N \times I_{s-avg} \times \frac{\pi}{2\sqrt{2}}\right)^2 + \left(\frac{V_{out}}{4\sqrt{3} \times N \times F_s \times L_m}\right)^2}$$

bestimmt wird, wobei $V_{in}$ die Eingangsspannung des Gleichstrom-Gleichstrom-Resonanzwandlers (1) ist, $C_r$ der Wert der Resonanzkapazitäten (Cr/2) ist, $F_s$ die Schaltfrequenz des Gleichstrom-Gleichstrom-Resonanzwandlers (1) ist, N das Wandlungsverhältnis des Transformators (Tr) bezeichnet, $I_{s\_avg}$ der Mittelwert des Ausgangsstroms ($I_s$) ist, $V_{out}$ die Ausgangsspannung ist und $L_m$ die primäre Magnetisierungsinduktivität des Transformators (Tr) bezeichnet.

**Claims**

1. Electrical system for converting a DC voltage into another DC voltage, comprising:

   • a DC/DC resonant converter (1) comprising an LLC resonant converter circuit comprising a resonance inductor (L), two resonance capacitors (Cr/2) and a transformer (Tr),
   • a control unit (TN) comprising:

      ◦ a first determination module (TN1) for determining the average value ($I_{s\_avg}$) of the output current ($I_s$) of the DC/DC resonant converter (1) over a time (T) called "evaluation time",

   **characterized in that** the control unit also comprises:

      ◦ a second determination module (TN2) for determining a maximum value ($V_{r\_max}$) of the voltage across the terminals of each resonance capacitor (Cr/2) and a minimum value ($V_{r\_min}$) of the voltage across the terminals of each resonance capacitor (Cr/2) over the evaluation time from the average value ($I_{s\_avg}$) of the output current ($I_s$) by expressing the maximum value ($V_{r\_max}$) and the minimum value ($V_{r\_min}$) of the voltage across the terminals of each resonance capacitor (Cr/2) as a function of the RMS value of the resonance current ($I_{r\_RMS}$), the RMS value of the resonance current ($I_{r\_RMS}$) being expressed as a function of the average value ($I_{s\_avg}$) of the output current ($I_s$) ,
      ◦ a comparison module (TNC) for comparing a maximum voltage threshold ($V_{r\_define\_max}$) with the maximum value ($V_{r\_max}$) of the voltage across the terminals of each resonance capacitor (Cr/2) and for comparing a minimum voltage threshold ($V_{r\_define\_min}$) with the minimum value ($V_{r\_min}$) of the voltage across the terminals of each resonance capacitor (Cr/2),
      ◦ a fault detection element (UP) configured to detect a fault of the DC/DC resonant converter (1) if:

         ▪ said maximum voltage value ($V_{r\_max}$) is greater than or equal to the maximum voltage threshold ($V_{r\_define\_max}$), or
         ▪ said minimum voltage value ($V_{r\_min}$) is less than or equal to the minimum voltage threshold ($V_{r\_define\_min}$).

2. Electrical system according to the preceding claim, wherein the DC/DC resonant converter (1) comprises a rectifier (20) connected to the secondary winding of the transformer (Tr).

3. Electrical system according to the preceding claim, wherein the first determination module (TN1) is configured to determine the average value ($I_{s\_avg}$) of the output current ($I_s$) from a measuring point located at an output terminal of the rectifier (20), in particular a low output terminal of the rectifier (20).

**4.** Electrical system according to one of the preceding claims, wherein the second determination module (TN2) is configured to determine the maximum voltage value ($V_{r\_max}$) and the minimum voltage value ($V_{r\_min}$) from: the input voltage ($V_{in}$) of the DC/DC resonant converter (1), the average value ($I_{s\_avg}$) of the output current ($I_s$), the switching frequency ($F_s$) of the DC/DC resonant converter (1), the capacitance of the resonance capacitor (Cr), the value of the output voltage $V_{out}$ of the rectifier (20), the transformation ratio (N) of the transformer (Tr) and the primary magnetizing inductance ($L_m$) of the transformer (Tr).

**5.** Electrical system according to one of the preceding claims, comprising a filter (30) connected to the output of the rectifier of the DC/DC resonant converter (1).

**6.** Electrical system according to one of the preceding claims, wherein the comparison module (TNC) is configured such that

said maximum voltage threshold ($V_{r\_define\_max}$) corresponds to a permitted maximum voltage value across the terminals of the resonance capacitor, in particular above which said capacitor is overloaded, and
said minimum voltage threshold ($V_{r\_define\_min}$) corresponds to a permitted minimum voltage value across the terminals of the resonance capacitor, in particular below which said resonance capacitor is overloaded.

**7.** Electrical system according to one of the preceding claims, wherein the fault detection element (UP) comprises a disconnect element configured to stop the operation of the DC/DC resonant converter (1) in the event of a fault.

**8.** Method for detecting an overload of a DC/DC resonant converter (1) implemented in an electrical system comprising a DC/DC resonant converter (1) comprising an LLC resonant converter circuit which comprises a resonance inductor (L), two resonance capacitors (Cr/2) and a transformer (Tr),

said method being **characterized in that** it comprises steps of:

• determining, in particular measuring, the output current ($I_s$),
• determining the average value ($I_{s\_avg}$) of said output current ($I_s$) over a time (T) called "evaluation time",

**characterized in that** the method also comprises the steps of:

• determining a maximum value ($V_{r\_max}$) of the voltage across the terminals of each resonance capacitor (Cr/2) and a minimum value ($V_{r\_min}$) of the voltage across the terminals of each resonance capacitor (Cr/2) over the evaluation time "T" from the average value ($I_{s\_avg}$) of the output current ($I_s$), determined in the preceding step, by expressing the maximum value ($V_{r\_max}$) and the minimum value ($V_{r\_min}$) of the voltage across the terminals of each resonance capacitor (Cr/2) as a function of the RMS value of the resonance current ($I_{r\_RMS}$), the RMS value of the resonance current ($I_{r\_RMS}$) being expressed as a function of the average value ($I_{s\_avg}$) of the output current ($I_s$),
• comparing a maximum voltage threshold ($V_{r\_define\_max}$) with the maximum value ($V_{r\_max}$) of the voltage across the terminals of each resonance capacitor (Cr/2) and comparing a minimum voltage threshold ($V_{r\_define\_min}$) with the minimum value ($V_{r\_min}$) of the voltage across the terminals of each resonance capacitor (Cr/2),
• detecting a fault of the DC/DC voltage resonant converter (1) if said maximum voltage value ($V_{r\_max}$) is greater than or equal to the maximum voltage threshold ($V_{r\_define\_max}$), and/or if said minimum voltage value ($V_{r\_min}$) is less than or equal to the minimum voltage threshold ($V_{r\_define\_min}$).

**9.** Method according to the preceding claim, wherein the fault detection step corresponds to the detection of an overload of a resonance capacitor (Cr/2).

**10.** Method according to Claim 8 or 9, comprising, after the step of detecting a fault, a step of disconnecting the DC/DC resonant converter (1), in which step the operation of the DC/DC resonant converter (1) is stopped.

**11.** Method according to one of Claims 8 to 10, wherein the maximum value ($V_{r\_max}$) of the voltage across the terminals of each resonance capacitor (Cr/2) is determined according to the formula:

$$V_{r\_max} = \frac{1}{2}V_{in} + \frac{\sqrt{2}}{C_r 2\pi F_s}\sqrt{(N \times I_{s\_avg} \times \frac{\pi}{2\sqrt{2}})^2 + (\frac{V_{out}}{4\sqrt{3} \times N \times F_s \times L_m})^2}$$

and the minimum value ($V_{r\_min}$) of the voltage across the terminals of each resonance capacitor (Cr/2) is determined according to the formula:

$$V_{r\_min} = \frac{1}{2}V_{in} - \frac{\sqrt{2}}{C_r 2\pi F_s}\sqrt{(N \times I_{s\_avg} \times \frac{\pi}{2\sqrt{2}})^2 + (\frac{V_{out}}{4\sqrt{3} \times N \times F_s \times L_m})^2}$$

where $V_{in}$ is the input voltage of the DC/DC resonant converter (1), $C_r$ is the capacitance of the resonance capacitors (Cr/2), $F_s$ is the switching frequency of the DC/DC resonant converter (1), N denotes the transformation ratio of the transformer (Tr), $I_{s\_avg}$ is the average value of the output current ($I_s$), $V_{out}$ is the output voltage and $L_m$ denotes the primary magnetizing inductance of the transformer (Tr).

FIG. 1

G1

HV — DC10 — LV
ENG
AUX

FIG. 2

Rectifier10

M3  M4
M1  M2
Vout

LLC

L1
C3  C4
Vr

ZVS10
C1  C2

HBS10
T1  T2
M1
Vin

FIG. 3

FIG. 4

FIG. 5

FIG. 6

EP 3 651 328 B1

**EP 3 651 328 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015229225 A1
- US 2014268907 A1
- EP 3588719 A